Europäisches Patentamt

(19) European Patent Office

Office européen des brevets

(11) Publication number: **0 215 951 B1**

# EUROPEAN PATENT SPECIFICATION

(45) Date of publication of patent specification:
27.02.91 Bulletin 91/09

(51) Int. Cl.⁵: **H04S 7/00, G10H 1/045, H03G 5/24**

(21) Application number: **86901490.2**

(22) Date of filing: **17.02.86**

(86) International application number:
**PCT/JP86/00070**

(87) International publication number:
**WO 86/05059 28.08.86 Gazette 86/19**

(54) **GRAPHIC BALANCER.**

(30) Priority: **18.02.85 JP 29871/85**

(43) Date of publication of application:
**01.04.87 Bulletin 87/14**

(45) Publication of the grant of the patent:
**27.02.91 Bulletin 91/09**

(84) Designated Contracting States:
**DE FR GB NL**

(56) References cited:
**JP-U- 5 933 400**
**US-A- 3 566 294**
**US-A- 4 046 960**

(73) Proprietor: **SONY CORPORATION**
**7-35 Kitashinagawa 6-Chome Shinagawa-ku**
**Tokyo 141 (JP)**

(72) Inventor: **KINOSHITA, Tsutomu**
**Sony Corporation 7-35, Kitashinagawa**
**6-chome**
**Shinagawa-ku Tokyo 141 (JP)**
Inventor: **OHTSU, Masahiro**
**Sony Corporation 7-35, Kitashinagawa**
**6-chome**
**Shinagawa-ku Tokyo 141 (JP)**
Inventor: **IDE, Teruhisa**
**Sony Corporation 7-35, Kitashinagawa**
**6-chome**
**Shinagawa-ku Tokyo 141 (JP)**

(74) Representative: **TER MEER - MÜLLER -**
**STEINMEISTER & PARTNER**
**Mauerkircherstrasse 45**
**D-8000 München 80 (DE)**

## Description

The present invention relates to a graphic balancer having two channels.

A graphic balancer as depicted in Fig. 1 is known from JP-U-59/33400. It comprises operational amplifiers 1L and 1R and resonators 2L and 2R for right and left channels. The resonators 2L and 2R are connected to movable terminals of volume controls 3L and 3R whose middlepoints are grounded. The volume controls 3L and 3R are connected between output terminals and negative feedback input terminals of the operational amplifiers 1L and 1R. The movable terminals of the volume controls 3L and 3R are synchronously moved in opposite directions. Therefore, when the volume control 3L in the left channel is moved to the left to increase the output gain, the movable terminal of the volume control 3R in the right channel is moved to the right, thereby decreasing the output level.

US-A-3,566,294 shows in its Fig. 14 a similar graphic balancer, however with the possibility to vary volume in a plurality of individual bands. Increase or decrease of the gain is carried out separately for each of the frequency bands or simultaneously for all of them.

It is the object of the present invention to provide a graphic balancer having a broader variety of usage.

The graphic balancer of the present invention comprises
a) first and second channel operational amplifiers, each having an input terminal, an output terminal and a feedback terminal,
b) a first volume control having a movable terminal, two end terminals and a center tap, said two end terminals being connected between the feedback and output terminals of said first channel operational amplifier with said tap being connected to a reference point,
c) a second volume control having a movable terminal, two end terminals and a center tap, said tap being connected to said reference point,
d) first and second resonators, respectively, connected between the movable terminals of said first and second volume controls and said reference point, and
e) switching means for selectively connecting said second volume control in such a way that the connection of two end terminals thereof are interchangeable between the feedback and output terminals of said second channel operational amplifier so as to select a specific equalizer characteristic or a balance characteristic.

Due to said switching means, the graphic balancer can be used also as a graphic equalizer. Switching between the two modes is provided by only operating the switching means. No additional components besides the switching means are necessary to provide the two modes.

In case that the balancer/equalizer comprises volume controls for several bands, there may be a single switching means for changing the mode within all bands or there may be a separate switching means for each band.

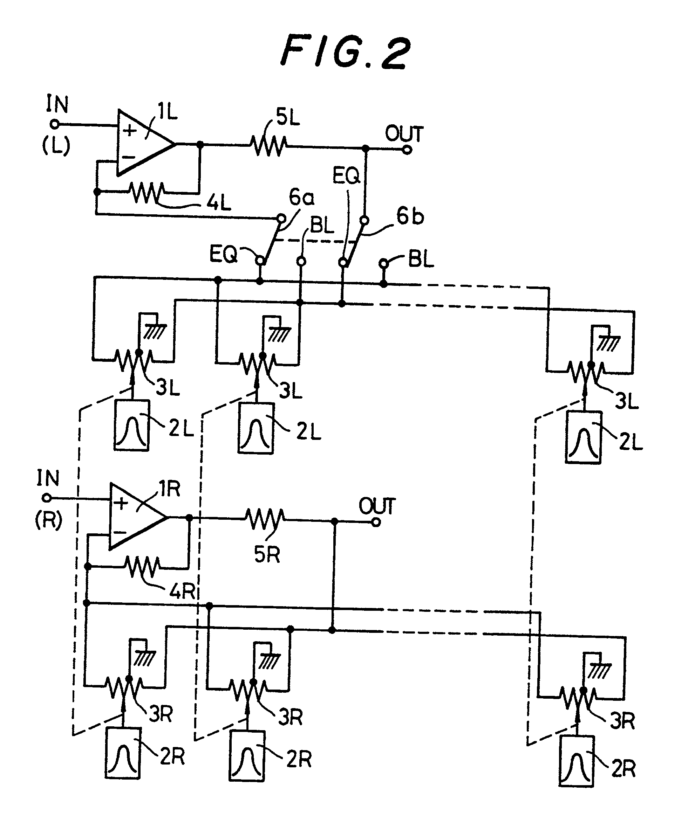

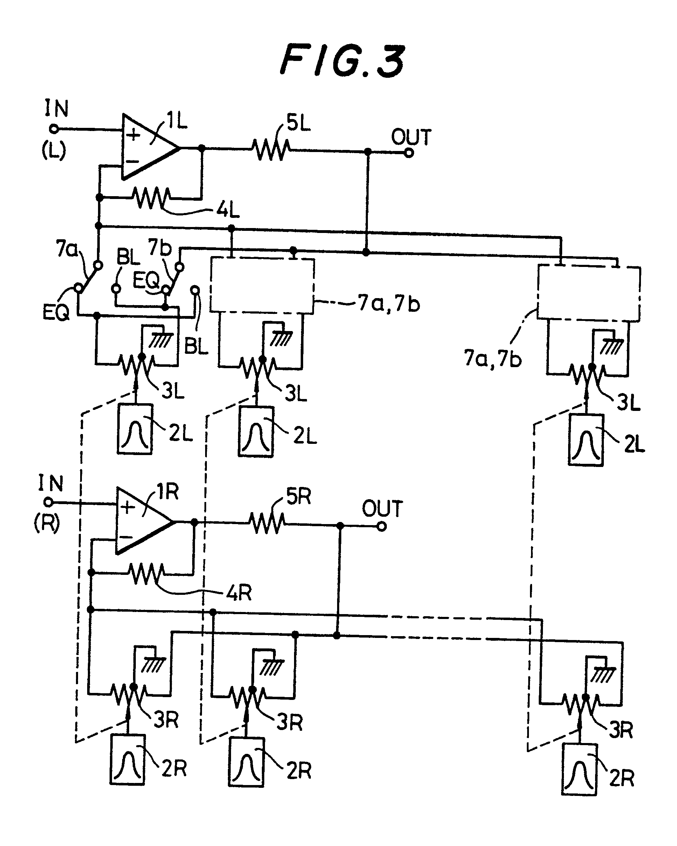

The invention will now be explained by two embodiments according to circuit diagrams of Fig. 2 and 3. The figures show :

Fig. 1 : a circuit diagram of a graphic balancer as known from JP-U-59/33400 ;

Fig. 2 : a circuit diagram of a graphic balancer/equalizer having a single, common switching means for a plurality of bands ; and

Fig. 3 : a circuit diagram similar to the diagram of Fig. 2, however, with separate switching means for each of a plurality of bands.

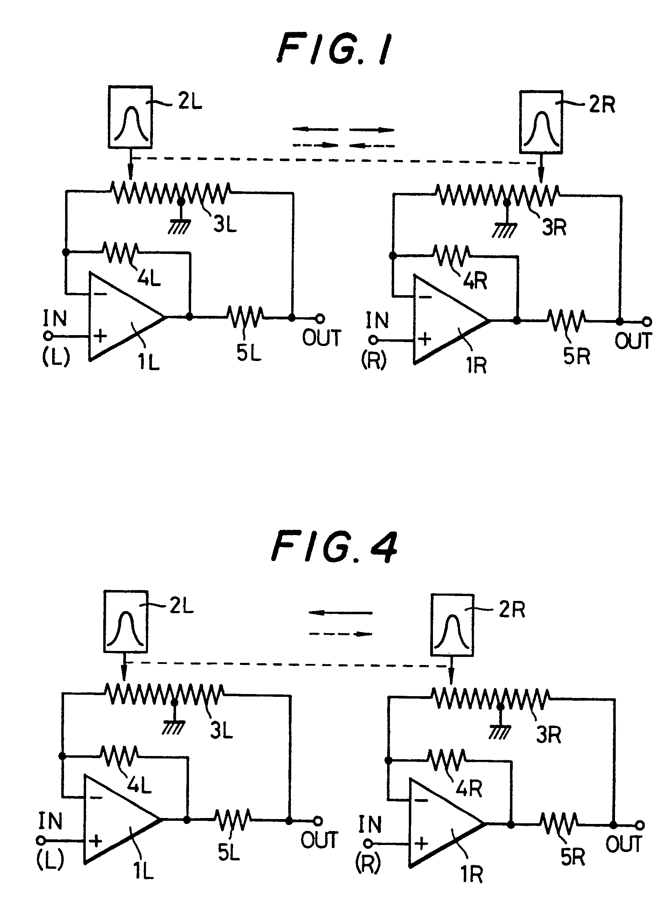

Fig. 2 shows a first embodiment wherein a graphic equalizer and a graphic balancer employs a common circuit to be switched over for use. Each channel is arranged such that the basic circuits shown in Fig. 1 are connected in parallel by the number of divided bands. In one channel (the left channel in Fig. 2), both terminals of each volume 3L connected in parallel are connected between the negative feedback input terminal of the operational amplifier 1L and one terminal of the output resistor 5L through interlinked switches 6a and 6b so as to be inversely (interchangeably) connected.

When the switches 6a and 6b are switched to the side of an equalizer EQ, the volume controls 3L and 3R in the left and right channels are moved in the same direction, thereby simultaneously controlling increase or decrease of the output levels of the right and left channels. When the switches 6a and 6b are switched to the side of a balancer BL, the volume controls 3L and 3R are moved in the opposite directions to increase the output level of one channel and decrease that of the other at each band, thereby synchronously performing this balancing operation.

Fig. 3 shows a second embodiment wherein the equalizer and the balancer can be switched over in each band. More specifically, there are provided switches 7a and 7b for inverting both terminals of each volume 3L in the left channel and connecting them to the operational amplifier 1L in individual bands. Therefore, the equalizer function or the balancer function can be selected in any band.

Note that in the above embodiments, a balanced (or an unbalanced) condition is displayed as a graph (a compensation curve) along the frequency axis by the position of control knobs or by a display means. Effect of the Invention.

## Claims

1. A graphic balancer comprising :

a) first and second channel operational amplifiers (1R, 1L), each having an input terminal, an output terminal and a feedback terminal,

b) a first volume control (3R) having a movable terminal, two end terminals and a center tap, said two end terminals being connected between the feedback and output terminals of said first channel operational amplifier with said tap being connected to a reference point,

c) a second volume control (3L) having a movable terminal, two end terminals and a center tap, said tap being connected to said reference point, and

d) first and second resonators (2R, 2L),respectively, connected between the movable terminals of said first and second volume controls and said reference point, **characterized by**

e) switching means (6a, 6b ; 7a, 7b) for selectively connecting said second volume control (3L) in such a way that the connection of two end terminals (EQ, BL) thereof are interchangeable between the feedback and output terminals of said second channel operational amplifier (1L) so as to select a specific equalizer characteristic or a balance characteristic.

2. A graphic balancer according to claim 1, characterized in that the respective end terminals of a plurality of second volume controls (3L) are connected in series and that said switching means (6a, 6b) switches between the common end terminals (Fig. 2).

3. A graphic balancer according to claim 1, characterized in that a separate switching means (7a, 7b) is provided for each second volume control (3L) in a plurality of bands (Fig. 3).

## Ansprüche

1. Graphischer Entzerrer mit :

a) Operationsverstärkern (1R, 1L) für einen ersten und einen zweiten Kanal mit Jeweils einem Eingangs-, einem Ausgangs-, und einem Rückkopplungsanschluß,

b) einem ersten Lautstärkeregler (3R) mit einem beweglichen Anschluß, zwei Endanschlüssen und einer Mittenanzapfung, wobei die beiden Endanschlüsse zwichen dem Rückkopplungs- und dem Ausgangschluß des Operationsverstärkers im ersten Kanal und die Mittenanzapfung an einen Referenzpunkt angeschlossen sind,

c) einem zweiten Lautstärkeregler (3L) mit einem verschiebbaren Anschluß, zwei Endanschlüssen und einer Mittenanzapfung welch letztere auf einen Referenzpunkt geschaltet ist, und mit

d) ersten und zweiten Resonatoren (2R, 2L), die zwischen den beweglichen Anschlüssen des ersten bzw. zweiten Lautstärkereglers und dem Referenzpunkt liegen, **gekennzeichnet durch,**

e) Schaltmittel (6a, 6b, 7a, 7b) zur wahlweisen Verbindung des zweiten Lautstärkereglers (3L) in der Weise, daß die Anschlüsse der beiden Endanschlüsse (EQ, BL) zwischen dem Rückkopplungs- und Ausgangsanschluß des Operationsverstärkers (1L) im zweiten Kanal austauschbar sind um eine bestimmte Entzerreroder Abgleich-Kennlinie zu wählen.

2. Graphischer Entzerrer nach Anspruch 1, **dadurch gekennzeichnet,** daß die Jeweiligen Endanschlußklemmen einer Mehrzahl von zweiten Lautstärkereglern (3L) in Reihe geschaltet sind, und daß die Schaltmittel (6a, 6b) eine Umschaltung zwischen den gemeinsamen Endanschlüssen bewirken (Fig. 2).

3. Graphischer Entzerrer nach Anspruch 1, **dadurch gekennzeichnet,** daß eine getrennte Umschalteinheit (7a, 7b) für Jeden der zweiten Lautstärkeregler (3L) für eine Mehrzahl von Bändern vorgesehen ist (Fig. 3).

## Revendications

1. Un équilibreur graphique comprenant :

a) des amplificateurs opérationnels de première voie et de seconde voie (1R, 1L), ayant chacun une borne d'entrée, une borne de sortie et une borne de contre-réaction,

b) un premier élément de commande de volume (3R) ayant une borne mobile, deux bornes d'extrémité et une prise centrale, ces deux bornes d'extrémité étant connectées entre les bornes de contre-réaction et de sortie de l'amplificateur opérationnel de la première voie, avec la prise connectée à un point de référence,

c) un second élément de commande de volume (3L) ayant une borne mobile, deux bornes d'extrémité et une prise centrale, cette prise étant connectée au point de référence, et

d) des premier et second résonateurs (2R, 2L) qui sont respectivement connectés entre les bornes mobiles des premier et second éléments de commande de volume et le point de référence, caractérisé par

e) des moyens de commutation (6a, 6b ; 7a, 7b) pour connecter sélectivement le second élément de commande de volume (3L) d'une manière telle que la connexion de ses deux bornes d'extrémité (EQ, BL) soit interchangeable entre les bornes de contre-réaction et de sortie de l'amplificateur opérationnel de la seconde voie (1L), afin de sélectionner une caractéristique d'égaliseur spécifique ou une caractéristique d'équilibreur.

2. Un équilibreur graphique selon la revendication 1, caractérisé en ce que les bornes d'extrémité respectives d'un ensemble de second éléments de commande de volume (3L) sont connectées en série, et en ce que les moyens de commutation (6a, 6b) effectuent une commutation entre les bornes d'extrémité communes (figure 2).

3. Un équilibreur graphique selon la revendication 1, caractérisé en ce qu'un moyen de commutation séparé (7a, 7b) est prévu pour chaque second élément de commande de volume (3L) dans un ensemble de bandes (figure 3).

EP 0 215 951 B1

# FIG. 1

# FIG. 4

5

# FIG.2

# FIG.3